# EUROPEAN PATENT APPLICATION

(11) **EP 4 120 546 A1**
(43) Date of publication of application: **18.01.2023**
(21) Application number: 21768836.5
(22) Date of filing: 16.02.2021
(51) Int. Cl.: H02N 11/00, H01L 37/00, H01L 35/26

(54) **POWER GENERATION ELEMENT, POWER GENERATION DEVICE, ELECTRONIC APPARATUS, AND MANUFACTURING METHOD FOR POWER GENERATION ELEMENT**

(30) Priority: 09.03.2020 JP 2020039952; 30.06.2020 JP 2020113330; 19.08.2020 JP 2020138916
(71) Applicant: GCE Institute Inc., Tokyo 104-0061 (JP)
(72) Inventor: GOTO, Hiroshi, Tokyo 104-0061 (JP); SAKATA, Minoru, Tokyo 104-0061 (JP); ANDERSSON, Lars Mattias, Tokyo 104-0061 (JP)
(74) Representative: Rings, Rolf
(86) International application number: PCT/JP2021/005616
(87) International publication number: WO 2021/182028

(57) **Abstract**

Provided is a power generation element that allows improvement of an output voltage, a power generation device, an electronic apparatus, and a manufacturing method for the power generation element. The power generation element includes a plurality of laminated bodies 1 laminated in a first direction. The plurality of laminated bodies 1 include a first electrode portion 10 that has a first main surface 11a and a second main surface 11b opposed to the first main surface 11a in the first direction and includes a substrate 11 having a conductive property, a second electrode 22 that is provided to be in contact with the first main surface 11a and has a work function different from a work function of the substrate 11, and an intermediate portion 14 that is provided on the second main surface 11b side and includes nanoparticles.

## Description

### TECHNICAL FIELD

This invention relates to a power generation element that converts thermal energy into electric energy, a power generation device, an electronic apparatus, and a manufacturing method for the power generation element.

### BACKGROUND ART

Recently, development of power generation elements that generate electric energy using thermal energy has been actively performed. Especially, for generation of electric energy using a difference in work functions that electrodes have, for example, a thermoelectric element disclosed in Patent Document 1 and the like have been proposed. Such a thermoelectric element is expected to be used for various applications compared with a configuration that generates electric energy using a temperature difference provided to electrodes.

Patent Document 1 discloses a thermoelectric element that converts thermal energy into electric energy. The thermoelectric element includes a laminated body having a first laminated portion and a second laminated portion laminated on the first laminated portion. Each of the first laminated portion and the second laminated portion has a base material having a main surface intersecting with a laminating direction of the laminated body, a wiring provided in the base material, a first electrode layer provided to be separated from the wiring along the laminating direction, a second electrode layer that is in contact with the wiring in the base material, provided between the first electrode layer and the wiring, and has a work function different from that of the first electrode layer, and an intermediate portion that is provided in the base material, provided to be in contact between the first electrode layer and the second electrode layer, and includes nanoparticles. The first electrode layer that the first laminated portion has is in contact with the wiring that the second laminated portion has, and the nanoparticles have a work function between the work function of the first electrode layer and the work function of the second electrode layer.

Patent Document 1: Japanese Patent No. 6411612

### DISCLOSURE OF THE INVENTION

### PROBLEMS TO BE SOLVED BY THE INVENTION

Here, when a power generation element is used as a power generation device, a configuration in which electrode parts are laminated is required to increase an obtained current or voltage. In this respect, in the thermoelectric element disclosed in Patent Document 1, the wiring that is provided in the base material and is in contact with the second electrode layer is disclosed. In view of this, there is a concern that resistance of the entire element caused by contact resistance between the electrodes and the wiring increases, hindering improvement of an output voltage.

Therefore, the present invention has been invented in consideration of the above problems and an object of the present invention is to provide a power generation element that allows improvement of an output voltage, a power generation device, an electronic apparatus, and a manufacturing method for the power generation element.

### SOLUTIONS TO THE PROBLEMS

A power generation element according to a first invention converts thermal energy into electric energy. The power generation element includes a plurality of laminated bodies that are laminated in a first direction. The plurality of laminated bodies include: a first electrode portion that has a first main surface and a second main surface opposed to the first main surface in the first direction and includes a substrate having a conductive property; a second electrode that is provided to be in contact with the first main surface and has a work function different from a work function of the substrate; and an intermediate portion that is provided on the second main surface side and includes nanoparticles.

In the power generation element according to a second invention, which is in the first invention, the substrate has a specific resistance value of 1 × 10⁻⁶Ω·cm or more and 1 × 10⁶Ω·cm or less.

In the power generation element according to a third invention, which is in the first invention, the substrate has a specific resistance value smaller than a specific resistance value of the intermediate portion.

In the power generation element according to a fourth invention, which is in the first invention, the first electrode portion includes a supporting portion that surrounds the intermediate portion and supports another of the laminated bodies, and the substrate has a specific resistance value smaller than a specific resistance value of the supporting portion.

In the power generation element according to a fifth invention, which is in the first invention, the first electrode portion includes a supporting portion that surrounds the intermediate portion and supports another of the laminated bodies, and the intermediate portion has a specific resistance value smaller than a specific resistance value of the supporting portion.

The power generation element according to a sixth invention, which is in the first invention, the substrate has a thickness of 0.03 mm or more and 1.0 mm or less.

In the power generation element according to a seventh invention, which is in the first invention, the substrate has a thickness of 1/10 or less of an outside dimension in a short side direction of the laminated bodies.

In the power generation element according to an eighth invention, which is in the first invention, the first electrode portion is provided between the substrate and the intermediate portion and includes a first electrode that is in contact with the second main surface.

In the power generation element according to a ninth invention, which is in the fourth invention, the supporting portion is an oxidized part of the substrate.

In the power generation element according to a tenth invention, which is in the first invention, the substrate is a semiconductor and has a degenerate portion provided on at least any of the first main surface and the second main surface, and a non-degenerate portion.

A power generation element according to an eleventh invention converts thermal energy into electric energy. The power generation element includes a laminated body that is laminated in a first direction and a connection layer. The laminated body includes: a first electrode portion that has a first main surface and a second main surface opposed to the first main surface in the first direction and includes a substrate having a conductive property; a second electrode that is provided to be in contact with the first main surface and has a work function different from a work function of the substrate; and an intermediate portion that is provided on the second main surface side and includes nanoparticles. The connection layer includes the substrate.

A power generation device according to a twelfth invention includes the power generation element according to the first invention.

An electronic apparatus according to a thirteenth invention includes the power generation element according to the first invention and an electronic part configured to be driven by using the power generation element as a power source.

A manufacturing method for a power generation element according to a fourteenth invention that converts thermal energy into electric energy. The manufacturing method includes: a first electrode portion formation step of forming a first electrode portion that has a first main surface and a second main surface opposed to the first main surface in a first direction and includes a substrate having a conductive property; a second electrode formation step of forming a second electrode having a work function different from a work function of the substrate so as to be in contact with the first main surface; a lamination step of laminating the second electrode and the first electrode portion in this order two or more times; and an intermediate portion formation step of forming an intermediate portion that includes nanoparticles between the second electrode and the second main surface.

### EFFECTS OF THE INVENTION

According to the first invention to the eleventh invention, the laminated body includes the first electrode portion that includes a substrate having a conductive property, the second electrode, and the intermediate portion. In view of this, wirings are not necessary between a plurality of laminated bodies, and an increase in resistance of the entire element can be suppressed. This allows improvement of an output voltage.

Especially, according to the second invention, the substrate has the specific resistance value of 1 × 10⁻⁶Ω·cm or more and 1 × 10⁶Ω·cm or less. In view of this, the resistance that increases in association with the number of lamination layers of the laminated body can be suppressed. This allows further improvement in power generation efficiency of the power generation element.

Especially, according to the third invention, the substrate has the specific resistance value smaller than the specific resistance value of the intermediate portion. In view of this, a resistance increase caused by the substrate in association with lamination can be suppressed. This allows further improvement in the power generation efficiency.

Especially, according to the fourth invention, the substrate has the specific resistance value smaller than the specific resistance value of the supporting portion. In view of this, conduction to the supporting portion can be avoided. This allows further improvement in the power generation efficiency.

Especially, according to the fifth invention, the intermediate portion has the specific resistance value smaller than the specific resistance value of the supporting portion. In view of this, the conduction to the supporting portion can be avoided. This allows further improvement in the power generation efficiency.

Especially, according to the sixth invention, the substrate has the thickness of 0.03 mm or more and 1.0 mm or less. In view of this, a size of the substrate can be decreased. This allows a decrease in dimensions of the entire power generation element.

Especially, according to the seventh invention, the substrate has the thickness of 1/10 or less of the outside dimension in the short side direction of the laminated body. In view of this, the thickness of the entire power generation element can be suppressed even when a plurality of substrates are stacked. This allows avoiding fall of the power generation element and allows avoiding deterioration of the power generation element in association with the fall.

Especially, according to the eighth invention, the first electrode portion is provided between the substrate and the intermediate portion and includes the first electrode that is in contact with the second main surface. In view of this, a size of an interelectrode gap can be set with high accuracy by controlling a thickness of the first electrode. This allows stabilization of the power generation efficiency.

Especially, according to the ninth invention, the supporting portion is an oxidized part of the substrate. In view of this, compared with a case where the supporting portion is newly formed, a height of the supporting portion can be controlled with high accuracy, and the size of the interelectrode gap can be set with high accuracy. This allows stabilization of the power generation efficiency.

Especially, according to the tenth invention, the substrate is a semiconductor and has a degenerate portion provided on at least any of the first main surface and the second main surface, and a non-degenerate portion. In view of this, compared with a configuration that does not have a degenerate portion, contact resistance of the second electrode and the like with other configurations can be reduced. This allows suppressing an increase in resistance of the entire element.

According to the twelfth invention, connection of an electric wiring to a thermoelectric element and an inspection of the thermoelectric element can be facilitated. In view of this, the power generation device that includes the thermoelectric element having an intermediate portion that is easily formed can be provided.

According to the thirteenth invention, connection of an electric wiring to a thermoelectric element and an inspection of the thermoelectric element can be facilitated. In view of this, the electronic apparatus including the thermoelectric element can be obtained.

According to the fourteenth invention, a power generation element is manufactured by a manufacturing method for the power generation element of the first invention to the ninth invention. In view of this, wirings are not necessary between a plurality of laminated bodies, and an increase in resistance of the entire element can be suppressed. This allows improvement of an output voltage.

### BRIEF DESCRIPTION OF THE DRAWINGS

Fig. 1A is a schematic cross-sectional view illustrating one example of a power generation element and a power generation device according to a first embodiment, and Fig. 1B is a schematic cross-sectional view taken along the line A-A in Fig. 1A.
Fig. 2 is a schematic cross-sectional view illustrating one example of an intermediate portion.
Fig. 3 is a flowchart illustrating one example of a manufacturing method for the power generation element according to the first embodiment.
Fig. 4A to Fig. 41 are schematic cross-sectional views illustrating one example of the manufacturing method for the power generation element according to the first embodiment.
Fig. 5 is a schematic cross-sectional view illustrating one example of a power generation element and a power generation device according to a second embodiment.
Fig. 6 is a schematic cross-sectional view illustrating one example of a power generation element and a power generation device according to a third embodiment.
Fig. 7A to Fig. 7D are schematic block diagrams illustrating an example of an electronic apparatus including the power generation element, and Fig. 7E to Fig. 7H are schematic block diagrams illustrating an example of an electronic apparatus including the power generation device that includes the power generation element.
Fig. 8 is a schematic perspective view illustrating one example of a power generation element and a power generation device according to a fifth embodiment.
Fig. 9 is a schematic cross-sectional view illustrating one example of the power generation element and the power generation device according to the fifth embodiment.

### DESCRIPTION OF PREFERRED EMBODIMENTS

The following describes one example of each of a power generation element and a manufacturing method for the power generation element as embodiments of the present invention with reference to the drawings. In each drawing, a height direction in which each electrode portion is laminated is defined as a first direction Z, one planar direction that intersects with or, for example, is perpendicular to, the first direction Z is defined as a second direction X, and another planar direction that intersects with or, for example, is perpendicular to, each of the first direction Z and the second direction X is defined as a third direction Y. Configurations in each drawing are schematically described for explanation, and for example, a size of each configuration, a contrast of the size in each configuration, and the like may be different from those in the drawings.

### (First Embodiment)

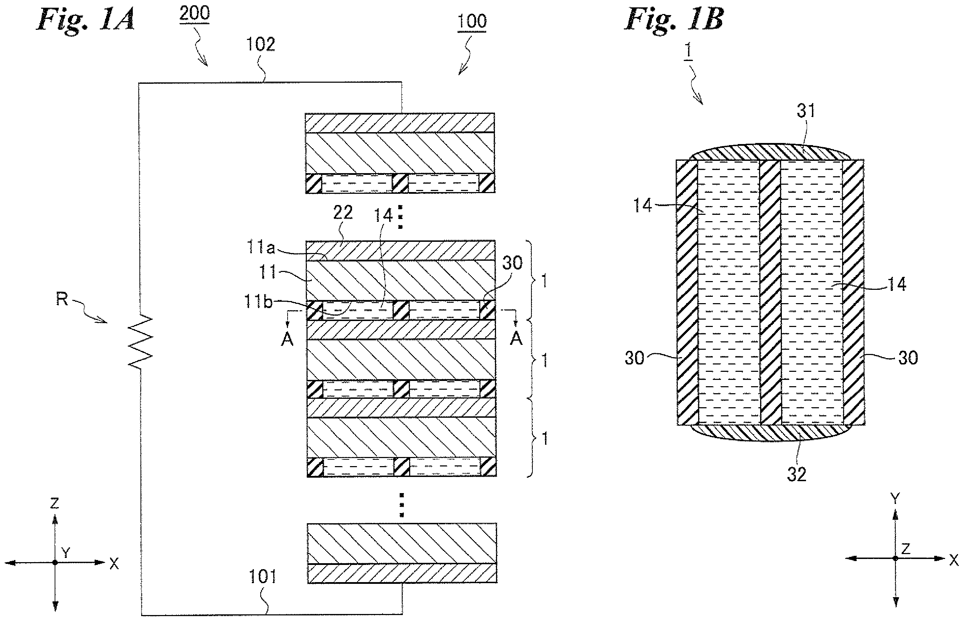

Fig. 1 is a schematic diagram illustrating one example of a power generation element 100 and a power generation device 200 according to a first embodiment. As illustrated in Fig. 1, the power generation element 100 includes a plurality of laminated bodies 1 that are laminated in the first direction. The number of the laminated bodies 1 constituting the power generation element 100 may be increased and decreased as necessary considering required electric power and is not especially limited.

### <Power Generation Device 200>

Fig. 1A is a schematic cross-sectional view illustrating one example of the power generation device 200 including the power generation element 100 according to the first embodiment.

As illustrated in Fig. 1A, the power generation device 200 includes the power generation element 100, a first wiring 101, and a second wiring 102. The power generation element 100 converts thermal energy into electric energy. The power generation device 200 including the power generation element 100 is, for example, mounted or installed to a heat source (not illustrated) and outputs the electric energy generated by the power generation element 100 based on the thermal energy of the heat source to a load R via the first wiring 101 and the second wiring 102. The load R has one end electrically connected to the first wiring 101 and the other end electrically connected to the second wiring 102. The load R indicates, for example, an electrical apparatus. The load R is driven using the power generation device 200 as a main power source or an auxiliary power source.

As the heat source of the power generation element 100, for example, an electronic device or an electronic part, such as a Central Processing Unit (CPU), a light-emitting element, such as a Light Emitting Diode (LED), an engine of an automobile or the like, a production facility of a plant, a human body, sunlight, an environmental temperature, and the like can be used. For example, the electronic device, the electronic part, the light-emitting element, the engine, the production facility, and the like are artificial heat sources. The human body, the sunlight, the environmental temperature, and the like are natural heat sources. The power generation device 200 including the power generation element 100 can be provided inside, for example, a mobile device, such as an Internet of Things (IoT) device and a wearable device, and a stand-alone sensor terminal and used as a substitute or an auxiliary for a battery. Furthermore, the power generation device 200 can be applied to a larger power generation device, such as a photovoltaic power generation system.

### <Power Generation Element 100>

The power generation element 100 converts, for example, the thermal energy generated by the above artificial heat source or the thermal energy that the above natural heat source has into electric energy to generate a current. Not only can the power generation element 100 be provided in the power generation device 200, but also the power generation element 100 itself can be provided inside the above mobile device, the above stand-alone sensor terminal, or the like. In this case, the power generation element 100 itself becomes a substituting part or an auxiliary part for the battery of the above mobile device, the above stand-alone sensor terminal, or the like.

The power generation element 100 includes the plurality of laminated bodies 1. Each of the laminated bodies 1 includes a first electrode portion 10, a second electrode 22, and intermediate portions 14. The first electrode portion 10 includes, for example, a substrate 11 and supporting portions 30. The substrate 11 has a first main surface 11a and a second main surface 11b opposed to the first main surface 11a in the first direction Z. The substrate 11 has a conductive property. The second electrode 22 is provided to be in contact with the first main surface 11a and has a work function different from that of the substrate 11. The intermediate portions 14 are provided on the second main surface 11b side and include nanoparticles 141. The intermediate portions 14 are surrounded by, for example, the supporting portions 30 and sealing portions (such as a first sealing portion 31 and a second sealing portion 32) and held in the laminated body 1.

### <Substrate 11>

The substrate 11 is a plate-shaped member having a conductive property. The substrate 11 has a thickness along the first direction Z of, for example, 0.03 mm or more and 1.0 mm or less. By setting the thickness of the substrate 11 to be in such a range, a thickness of the power generation element 100 can be thin. On the other hand, when the thickness of the substrate 11 falls below 0.03 mm, the substrate 11 becomes easy to deform and a thickness of the intermediate portion 14 becomes difficult to control. When the thickness of the substrate 11 is thicker than 1.0 mm, dimensions of the power generation element 100 excessively increase.

It is only necessary that the thickness of the substrate 11 is, for example, 1/10 or less of an outside dimension in a short side direction (second direction X in Fig. 1B) of the laminated body 1. By setting such a condition for the thickness of the substrate 11, the thickness of the power generation element 100 can be thin. However, if the thickness of the substrate 11 is out of this range, an inconvenience that the thickness of the power generation element 100 increases occurs. The substrate 11 has a width in the second direction X larger than a width in the second direction X of the intermediate portion 14.

As a material of the substrate 11, a metallic material having a conductive property can be selected. Examples of the metallic material can include, for example, iron, aluminum, copper, an alloy of aluminum and copper, or the like. As the material of the substrate 11, for example, besides a semiconductor having a conductive property, such as Si and GaN, a conductive high-polymer material may be used.

The substrate 11 has the first main surface 11a and the second main surface 11b. In the following description, a surface on a side (upper side in the first direction Z) that is in contact with the second electrode 22 is defined as the first main surface 11a, a surface on a side (lower side in the first direction Z) on which the intermediate portions 14 or the supporting portions 30 are provided is defined as the second main surface 11b. A shape of the substrate 11 may be square, rectangular, and in addition, disk-shaped.

It is only necessary that a specific resistance value of the substrate 11 is, for example, 1×10⁻⁶Ω·cm or more and 1×10⁶Ω·cm or less. When the specific resistance value of the substrate 11 falls below 1×10⁻⁶Ω·cm, the material is difficult to select. When the specific resistance value of the substrate 11 is larger than 1×10⁶Ω·cm, a loss of a current increases.

Additionally, it is only necessary that the specific resistance value of the substrate 11 is, for example, a value smaller than a specific resistance value of the intermediate portion 14 and a specific resistance value of the supporting portion 30. If the specific resistance value of the substrate 11 is larger than the specific resistance value of the intermediate portion 14 and the specific resistance value of the supporting portion 30, there is a concern that a high output voltage cannot be obtained.

### <Second Electrode>

The second electrode 22 is provided on the first main surface 11a and has a work function different from that of the substrate 11. The second electrode 22 may be composed of any material as long as a work function difference is generated between the second electrode 22 and the substrate 11. For example, the material can be selected from metals shown below:
Platinum (Pt)
Tungsten (W)
Aluminum (Al)
Titanium (Ti)
Niobium (Nb)
Molybdenum (Mo)
Tantalum (Ta)
Rhenium (Re)

As a material of the second electrode 22, a non-metal conductive substance can be selected. Examples of the non-metal conductive substance can include silicon (Si: such as p-type Si or n-type Si), a carbon-based material, such as graphene, and the like.

The second electrode 22 has a thickness along the first direction Z of, for example, 4 nm or more and 1 µm or less. More preferably, the thickness is 4 nm or more and 50 nm or less.

### <Intermediate Portion>

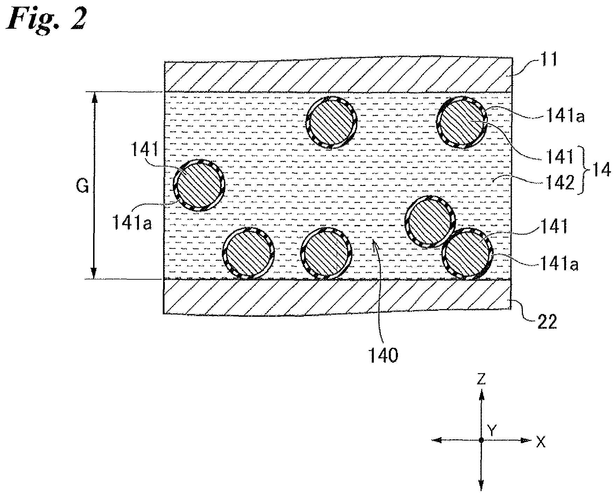

Fig. 2 is a schematic cross-sectional view illustrating one example of the intermediate portion 14. As illustrated in Fig. 1, the intermediate portions 14 are positioned on a lower portion side of the laminated body 1, and when a plurality of laminated bodies 1 are laminated, the intermediate portions 14 are provided between the substrate 11 of the laminated body 1 on the upper side and the second electrode 22 of the laminated body 1 on the lower side. The intermediate portion 14 includes the nanoparticles 141 having a work function between the work function of the substrate 11 and the work function of the second electrode 22.

Between the substrate 11 and the second electrode 22, an interelectrode gap G is configured along the first direction Z. In the power generation element 100, the interelectrode gap G is configured by a thickness along the first direction Z of the supporting portion 30. One example of a width of the interelectrode gap G is, for example, a finite value of 10 µm or less. The narrower the width of the interelectrode gap G, the more power generation efficiency of the power generation element 100 improves. The narrower the width of the interelectrode gap G, the thinner the thickness along the first direction Z of the power generation element 100 can be. In view of this, for example, the width of the interelectrode gap G is preferably narrow. More preferably, the width of the interelectrode gap G is, for example, 10 nm or more and 100 nm or less. The width of the interelectrode gap G is approximately equivalent to the thickness along the first direction Z of the supporting portion 30.

The intermediate portion 14 includes, for example, a plurality of nanoparticles 141 and a solvent 142. The plurality of nanoparticles 141 are dispersed in the solvent 142. The intermediate portion 14 is obtained by, for example, filling a gap portion 140 with the solvent 142 in which the nanoparticles 141 are dispersed. The nanoparticles 141 have a particle diameter smaller than the interelectrode gap G The particle diameter of the nanoparticles 141 is, for example, a finite value of 1/10 or less of the interelectrode gap G When the particle diameter of the nanoparticles 141 is set to 1/10 or less of the interelectrode gap G, the intermediate portion 14 including the nanoparticles 141 is easy to form in the gap portion 140. This allows improvement in working efficiency when the power generation element 100 is produced.

The nanoparticles 141 contain, for example, a conductive substance. A value of the work function of the nanoparticles 141 lies between, for example, a value of the work function of the substrate 11 and a value of the work function of the second electrode 22. For example, the value of the work function of the nanoparticles 141 falls within a range of 3.0 eV or more and 5.5 eV or less. This allows further increasing an amount of electric energy generation compared with a case where the nanoparticles 141 are not in the intermediate portion 14. The value of the work function of the nanoparticles 141 may lie other than between the value of the work function of the substrate 11 and the value of the work function of the second electrode 22.

As an example of a material of the nanoparticles 141, at least one of gold and argentum can be selected. It is only necessary that the value of the work function of the nanoparticles 141 lies between the value of the work function of the substrate 11 and the value of the work function of the second electrode 22. Accordingly, as the material of the nanoparticles 141, a conductive material other than gold or argentum can be selected.

The particle diameter of the nanoparticles 141 is, for example, 2 nm or more and 10 nm or less. The nanoparticles 141 may have, for example, a particle diameter of 3 nm or more and 8 nm or less in average particle diameter (or median diameter D50). The average particle diameter can be measured by using, for example, a particle size distribution measuring instrument. As the particle size distribution measuring instrument, it is only necessary to use, for example, a particle size distribution measuring instrument (such as Nanotrac Wave II-EX150 manufactured by MicrotracBEL) using a laser diffraction scattering method.

The nanoparticle 141 has, for example, an insulating film 141a on a surface of the nanoparticle 141. As an example of a material of the insulating film 141a, at least one of an insulating metal compound and an insulating organic compound can be selected. Examples of the insulating metal compound can include, for example, silicon oxide, alumina, and the like. Examples of the insulating organic compound can include alkanethiol (such as dodecanethiol) and the like. A thickness of the insulating film 141a is, for example, a finite value of 20 nm or less. By providing the insulating film 141a on the surface of the nanoparticle 141, electrons e can move, for example, between the substrate 11 and the nanoparticles 141 and between the nanoparticles 141 and the second electrode 22 using a tunneling effect. In view of this, for example, improvement in the power generation efficiency of the power generation element 100 can be expected.

For example, a liquid having a boiling point of 60°C or more can be used for the solvent 142. In view of this, even when the power generation element 100 is used under an environment having a room temperature (for example, 15°C to 35°C) or more, vaporization of the solvent 142 can be suppressed. This allows suppressing deterioration of the power generation element 100 in association with the vaporization of the solvent 142. As an example of the liquid, at least one of an organic solvent and water can be selected. Examples of the organic solvent can include methanol, ethanol, toluene, xylene, tetradecane, alkanethiol, and the like. The solvent 142 is preferably a liquid having a high electric resistance value and an insulating property.

The intermediate portion 14 may include only the nanoparticles 141 without including the solvent 142. By only including the nanoparticles 141 by the intermediate portion 14, for example, the vaporization of the solvent 142 does not need to be considered even when the power generation element 100 is used under a high temperature environment. This allows suppressing deterioration of the power generation element 100 under the high temperature environment.

### <Supporting Portion>

The supporting portions 30 are provided, for example, integrally with the substrate 11 in the first electrode portion 10. The supporting portions 30 surround the intermediate portions 14 and support another laminated body 1. The supporting portion 30 has a specific resistance value larger than the specific resistance value of the intermediate portion 14.

### <Operation of Power Generation Element 100>

When thermal energy is provided to the power generation element 100, a current is generated between the substrate 11 and the second electrode 22 and the thermal energy is converted into electric energy. An amount of the current generated between the substrate 11 and the second electrode 22 depends on the thermal energy and also depends on the difference between the work function of the second electrode 22 and the work function of the substrate 11.

The amount of the generated current can be increased by, for example, increasing the work function difference between the substrate 11 and the second electrode 22 and decreasing the interelectrode gap. For example, the amount of the electric energy generated by the power generation element 100 can be increased by considering at least any one of increasing the above work function difference and decreasing the above interelectrode gap.

### «Manufacturing Method for Power Generation Element 100»

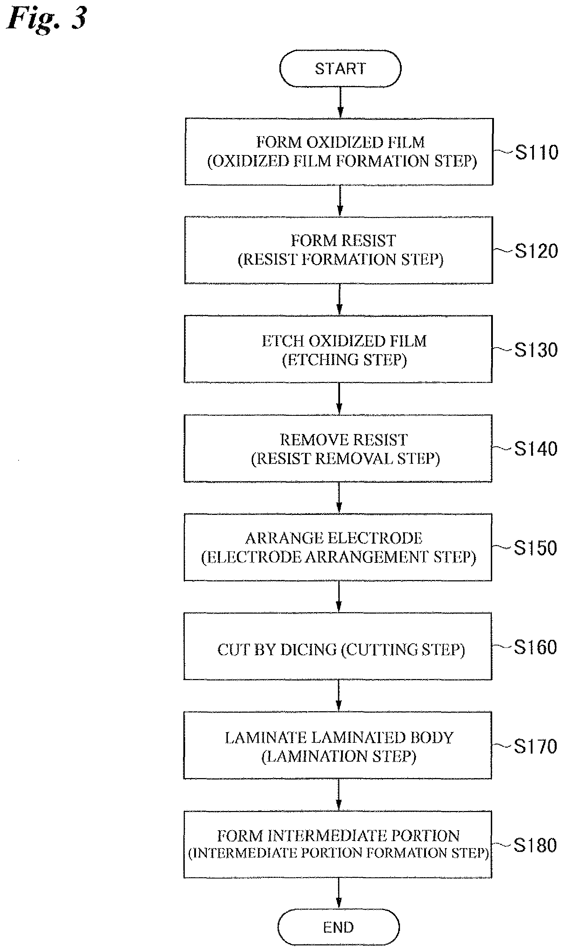

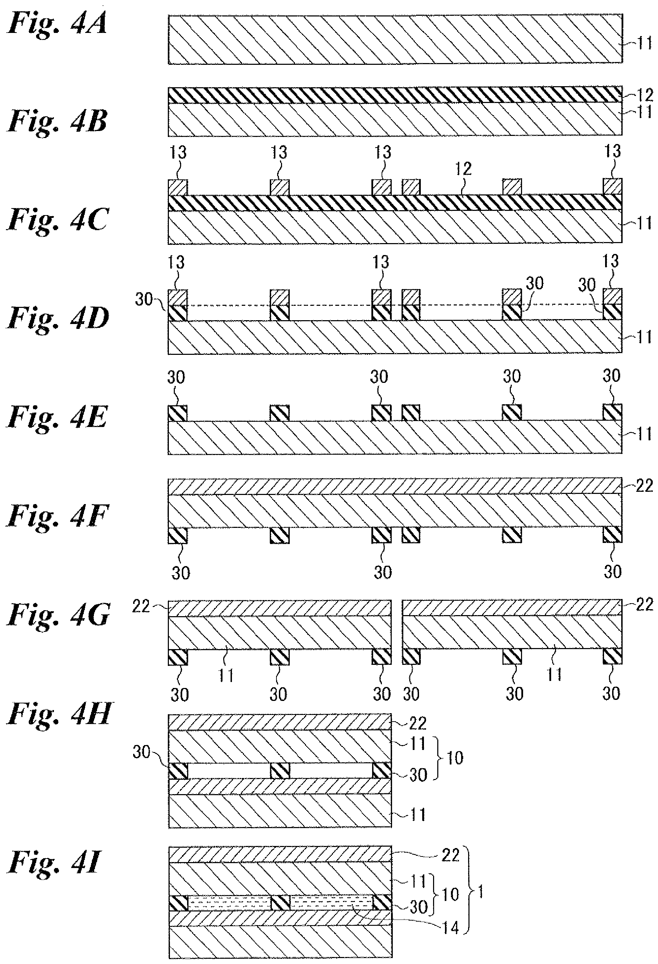

Next, one example of a manufacturing method for the power generation element 100 will be described. Fig. 3 is a flowchart illustrating one example of the manufacturing method for the power generation element 100 according to the first embodiment. Fig. 4A to Fig. 41 are schematic cross-sectional views illustrating one example of the manufacturing method for the power generation element 100 according to the first embodiment.

### <Oxidized Film Formation Step: S110>

First, on a surface (for example, the second main surface 11b) at one side of the substrate 11 having a conductive property as illustrated in Fig. 4A, an oxidized film 12 (supporting portions 30) as illustrated in Fig. 4B is formed (oxidized film formation step: S110). In the oxidized film formation step S110, an annealing process is performed on the substrate 11 main body at a high temperature to form the oxidized film 12 on the substrate 11. In the oxidized film formation step S110, for example, the oxidized film 12 is applied using a sputtering method or an evaporation method, and in addition to that, for example, the oxidized film 12 may be formed using a screen-printing method, an inkjet method, a spray-printing method, and the like. In the oxidized film formation step S110, a silicon oxide film is used as the oxidized film 12, and in addition to that, a polymer, such as polyimide, Polymethyl methacrylate (PMMA), or polystyrene, may be used.

### <Resist Formation Step: S120>

Next, as illustrated in Fig. 4C, resists (photoresists) 13 are formed on the oxidized film 12 (resist formation step: S120). In the formation of the resists 13, first, the resist 13 is applied on the oxidized film 12 by a spin coating method. Next, the applied resist 13 is exposed to light using a predetermined photomask. After the exposure to light, the resist 13 is developed.

In the development of the photoresist, the resist 13 that has been exposed to light is removed. As illustrated in Fig. 4C, the resists 13 that remain after the development are arranged on the oxidized film 12 at intervals. Positions of the resists 13 on the oxidized film 12 correspond to positions where the supporting portions 30 are formed. Note that each process of the application, the exposure to light, and the development of the photoresist may be performed using a known technique.

### <Etching Step: S130>

Next, as illustrated in Fig. 4D, etching is performed to remove parts of the oxidized film 12 that are not covered with the resists 13 (etching step: S130). A pattern process is performed on the oxidized film 12 so that the parts that are not covered with the resists 13 are removed by etching. As a result of the pattern process, the parts of the oxidized film 12 that are covered with the resists 13 are not removed and are formed as the supporting portions 30. The supporting portions 30 may be formed by oxidizing a part of the substrate 11.

### <Resist Removal Step: S140>

Next, as illustrated in Fig. 4E, the resists 13 are removed (resist removal step: S140). Specifically, since the formation of the supporting portions 30 is completed, the resists 13 used for forming the supporting portions 30 are removed.

### <Electrode Arrangement Step: S150>

Next, as illustrated in Fig. 4F, the second electrode 22 is arranged on the substrate 11 (electrode arrangement step: S150). Specifically, the second electrode 22 is arranged on the first main surface 11a on which the supporting portions 30 are not arranged in the substrate 11.

### <Cutting Step: S160>

Next, as illustrated in Fig. 4G, the substrate 11 is cut together with the second electrode 22 (cutting step: S160). Specifically, the substrate 11 and the second electrode 22 are cut by dicing along a central portion in the width direction of the substrate 11. As a result of cutting by dicing, a plurality of first electrode portions 10 having an identical thickness are formed. Positions of dicing the substrate 11 are arbitrary. The steps from the oxidized film formation step S110 to the cutting step S160 may be performed multiple times.

### <Lamination Step: S170>

Next, as illustrated in Fig. 4H, lamination is performed in a state where the second electrode 22 is opposed to the second main surface 11b of the first electrode portion 10 (lamination step: S170). Specifically, the second electrode 22 on the lower side and the supporting portions 30 of the first electrode portion 10 on the upper side are arranged along the first direction Z so as to be in contact with one another. In the arrangement of the first electrode portion 10 on the second electrode 22, materials of the second electrode 22 and the supporting portions 30 are preferably identical. For example, it is only necessary to preliminarily form the material of the second electrode 22 on leading ends of the supporting portions 30, or it is only necessary to preliminarily form the material of the supporting portions 30 on the second electrode 22.

### <Intermediate Portion Formation Step: S180>

Next, as illustrated in Fig. 41, the intermediate portions 14 including nanoparticles 141 are formed between the second electrode 22 and the second main surface 11b of the first electrode portion 10 (intermediate portion formation step: S180). Specifically, the intermediate portions 14 are formed in spaces formed by the second electrode 22 of the first electrode portion 10 on the lower side and the substrate 11 and the supporting portions 30 of the first electrode portions 10 on the upper side. The formation of the intermediate portions 14 is performed by, for example, injecting the solvent 142 including the plurality of nanoparticles 141 by capillarity and the like.

By performing the process of each of the steps S 110 to S180 described above, the power generation element 100 in which the plurality of laminated bodies 1 are laminated is formed. The process of each of the steps S110 to S180 described above may be performed multiple times.

Note that a first electrode portion formation step corresponds to, for example, the oxidized film formation step (S110) to the resist removal step (S140) according to the embodiment, a second electrode formation step corresponds to, for example, the electrode arrangement step (S150) according to the embodiment, a lamination step corresponds to, for example, the lamination step (S170) according to the embodiment, and an intermediate portion formation step corresponds to, for example, the intermediate portion formation step (S180) according to the embodiment.

According to the embodiment, the power generation element 100 in which two or more laminated bodies 1, in each of which the second electrode 22, the first electrode portion 10, and the intermediate portions 14 are laminated in this order, are laminated is formed. In view of this, a wiring between respective layers is not necessary at the time of the lamination. This allows improvement of an output voltage. Additionally, in association with the wiring becoming not necessary, structural simplification of the power generation element 100 can be ensured.

According to the embodiment, the substrate 11 has the specific resistance value of 1 × 10⁻⁶Ω·cm or more and 1 × 10⁶Ω·cm or less. In view of this, the resistance to the generated current can be suppressed. This allows improvement in the power generation efficiency of the power generation element 100.

According to the embodiment, the substrate 11 has the specific resistance value smaller than the specific resistance value of the intermediate portion 14. In view of this, a resistance increase caused by the substrate in association with the lamination can be suppressed. This allows further improvement in the power generation efficiency.

According to the embodiment, the substrate 11 has the specific resistance value smaller than the specific resistance value of the supporting portion 30. In view of this, conduction to the supporting portions 30 can be avoided. This allows further improvement in the power generation efficiency.

According to the embodiment, the intermediate portion 14 has the specific resistance value smaller than the specific resistance value of the supporting portion 30. In view of this, the conduction to the supporting portions 30 can be avoided. This allows further improvement in the power generation efficiency.

According to the embodiment, the substrate 11 has the thickness of 0.03 mm or more and 1.0 mm or less. In view of this, a size of the substrate 11 can be decreased. This allows a decrease in dimensions of the entire power generation element 100.

According to the embodiment, the substrate 11 has the thickness of 1/10 or less of the outside dimension in the short side direction of the laminated body 1. In view of this, the thickness of the entire power generation element 100 can be suppressed even when a plurality of the substrates 11 are stacked. This allows avoiding fall of the power generation element 100 and allows avoiding deterioration of the power generation element 100 in association with the fall.

The supporting portions 30 may be formed by oxidizing a part of the substrate 11. In view of this, the part of the substrate 11 functions as the supporting portions 30. This allows easily forming the supporting portions 30.

### (Second Embodiment)

Next, the power generation element 100 and the power generation device 200 according to a second embodiment will be described. A difference between the above-described first embodiment and the second embodiment is a point that the first electrode portion 10 has first electrodes 21 in addition to the substrate 11 and the supporting portions 30, and other points are common. Therefore, in the following description, the point different from the first embodiment will be mainly described, and identical reference numerals are attached to the common points and their descriptions will be omitted.

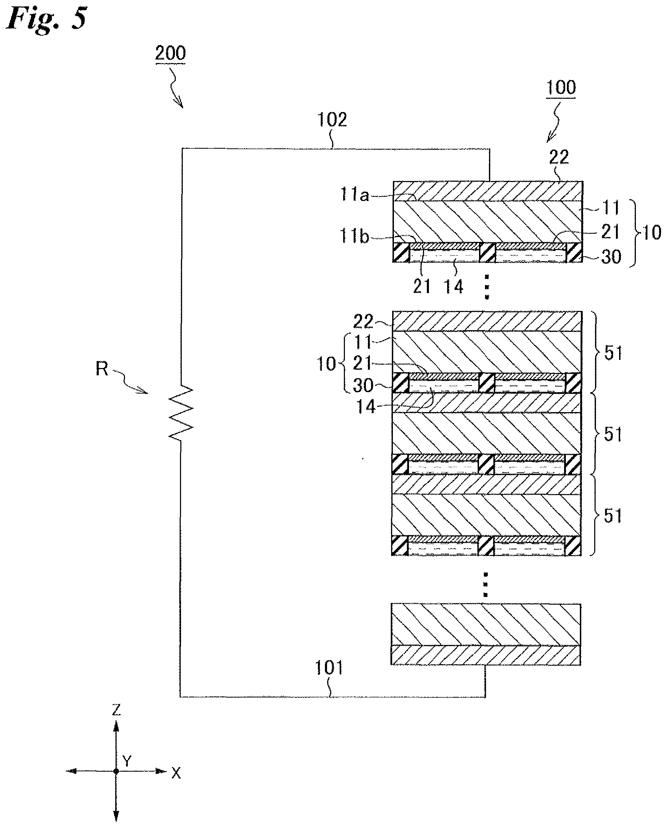

Fig. 5 is a schematic diagram illustrating one example of the power generation element 100 and the power generation device 200 according to the second embodiment. Each laminated body 51 is configured to have the first electrode portion 10, the second electrode 22, and the intermediate portions 14. The first electrode portion 10 has the substrate 11 and the first electrodes 21. The first electrode 21 is provided to be in contact with the second main surface 11b and arranged between the substrate 11 and the intermediate portion 14 in a state of being sandwiched by a pair of supporting portions 30. The first electrode 21 may have a work function larger than the work function of the second electrode 22, and the work function of the second electrode 22 may be larger than the work function of the first electrode 21.

The first electrode 21 may be arranged in a state of being sandwiched by the supporting portions 30 and the substrate 11 in the first direction Z, not in a state of being sandwiched by the pair of supporting portions 30. That is, in the laminated body 51, the second electrode 22, the substrate 11, the first electrode 21, and the supporting portions 30 may be laminated in this order. The first electrode 21 may be formed of a material identical to that of the second electrode 22 or may be formed of a different material.

According to the embodiment, the first electrode portion 10 is provided between the substrate 11 and the intermediate portions 14 and includes the first electrodes 21 that are in contact with the second main surface 11b. In view of this, a size of an interelectrode gap can be set with high accuracy by controlling a thickness of the first electrode 21. This allows stabilization of the power generation efficiency.

### (Third Embodiment)

Next, the power generation element 100 and the power generation device 200 according to a third embodiment will be described. A difference between the above-described first embodiment and the third embodiment is a point that the substrate 11 is a semiconductor and the substrate 11 has degenerate portions 62 and a non-degenerate portion 63, and other points are common. Therefore, in the following description, the point different from the first embodiment will be mainly described, and identical reference numerals are attached to the common points and their descriptions will be omitted.

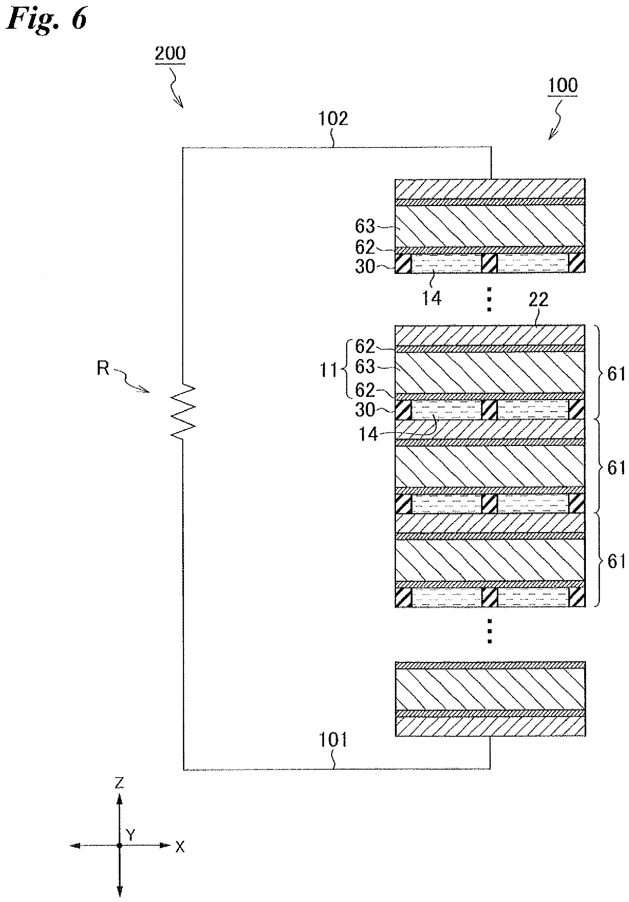

Fig. 6 is a schematic diagram illustrating one example of the power generation element 100 and the power generation device 200 according to the third embodiment. Each laminated body 61 is configured to have the second electrode 22, the first electrode portion 10, and the intermediate portions 14. The substrate 11 has the degenerate portions 62 in which a part of a surface is degenerate and the non-degenerate portion 63 that is not degenerate. Specifically, the degenerate portion 62 is provided on at least any of the first main surface 11a of the substrate 11 upper side and the second main surface 11b on the lower side, and the non-degenerate portion 63 is provided between a pair of degenerate portions 62. The second electrode 22 and the intermediate portions 14 are arranged in a state of being in contact with the degenerate portion 62. The substrate 11 is a semiconductor, and for example, the substrate 11 may be formed of any of n-type silicon in which pentavalent elements, such as phosphorus, are added in silicon as impurities, n-ZnO, n-InGaZnO, n-MgZnO, or n-InZnO or may be an n-type semiconductor other than these.

The degenerate portion 62 is generated by, for example, performing ion implantation of n-type dopant to the semiconductor at a high concentration, or by coating a material containing n-type dopant, such as glass, on the semiconductor and performing heat treatment after coating.

By forming the degenerate portion 62 in the substrate 11, resistance is reduced compared with a case where the degenerate portion 62 is not formed. In view of this, a current can be efficiently generated between the substrate 11 and the second electrode 22. This allows reduction in the resistance of the power generation element 100. A formation of the degenerate portion 62 is performed before, for example, the above-described oxidized film formation step S110. At this time, the degenerate portion 62 is formed on the surface of the substrate 11.

The degenerate portion 62 may be provided only on any one side of the first main surface 11a or the second main surface 11b. However, by providing the degenerate portion 62 on both the first main surface 11a and the second main surface 11b, the current can be generated more efficiently compared with a case where the degenerate portion 62 is provided only on one side. The impurities doped in the substrate 11 are P, As, Sb, or the like for an n-type and B, Ba, Al, or the like for a p-type, but are not limited to these. Additionally, as long as a concentration of the impurities of the degenerate portion 62 is 1×10¹⁹ ion/cm³, the electrons e can be efficiently emitted. However, as long as a Fermi level is sufficiently larger than a conduction band-end energy and what is called a degenerate state can be achieved, the concentration is not limited to this range.

According to the embodiment, the substrate 11 is a semiconductor and has the degenerate portion 62 in which the impurities are doped and the non-degenerate portion 63 in which the impurities are not doped. In view of this, the current is generated more efficiently. This improves the power generation efficiency of the power generation element 100.

### (Fourth Embodiment: Electronic Apparatus 500)

### <Electronic Apparatus 500>

The above-described power generation element 100 and the power generation device 200 can be mounted in, for example, an electronic apparatus. The following describes some embodiments of the electronic apparatus.

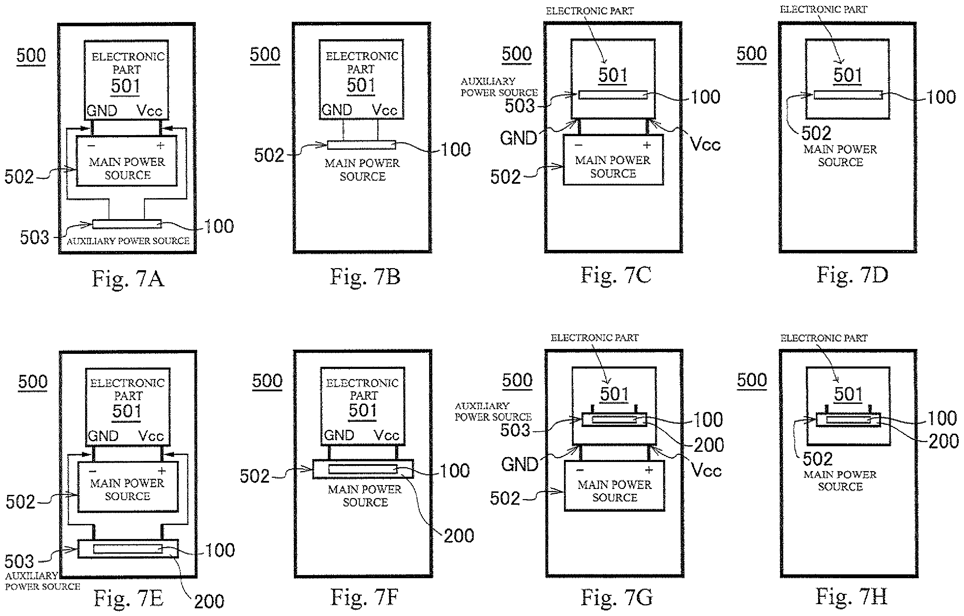

Fig. 7A to Fig. 7D are schematic block diagrams illustrating an example of an electronic apparatus 500 including the power generation element 100. Fig. 7E to Fig. 7H are schematic block diagrams illustrating an example of the electronic apparatus 500 including the power generation device 200 that includes the power generation element 100.

As illustrated in Fig. 7A, the electronic apparatus 500 (electric product) includes an electronic part 501 (electronic component), a main power source 502, and an auxiliary power source 503. Each of the electronic apparatus 500 and the electronic part 501 is an electrical apparatus (electrical device).

The electronic part 501 is driven using the main power source 502 as a power source. Examples of the electronic part 501 can include, for example, a CPU, a motor, a sensor terminal, a light, and the like. When the electronic part 501 is, for example, a CPU, the electronic apparatus 500 includes an electronic apparatus controllable by a built-in master (CPU). When the electronic part 501 includes, for example, at least one of a motor, a sensor terminal, a light, and the like, the electronic apparatus 500 includes an electronic apparatus controllable by an external master or a human.

The main power source 502 is, for example, a battery. As the battery, a rechargeable battery is also included. The main power source 502 has a plus terminal (+) electrically connected to a Vcc terminal (Vcc) of the electronic part 501. The main power source 502 has a minus terminal (-) electrically connected to a GND terminal (GND) of the electronic part 501.

The auxiliary power source 503 is the power generation element 100. The power generation element 100 includes at least one of the above-described power generation element 100. The power generation element 100 has an anode (for example, a first electrode portion 13a) electrically connected to the GND terminal (GND) of the electronic part 501, the minus terminal (-) of the main power source 502, or a wiring that connects the GND terminal (GND) to the minus terminal (-). The power generation element 100 has a cathode (for example, a second electrode portion 13b) electrically connected to the Vcc terminal (Vcc) of the electronic part 501, the plus terminal (+) of the main power source 502, or a wiring that connects the Vcc terminal (Vcc) to the plus terminal (+). In the electronic apparatus 500, the auxiliary power source 503 is used in combination with, for example, the main power source 502, and can be used as a power source for backing up the main power source 502 when capacities of the power source for assisting the main power source 502 and the main power source 502 run out. When the main power source 502 is a rechargeable battery, the auxiliary power source 503 can be also used as a power source for charging the battery.

As illustrated in Fig. 7B, the main power source 502 may be the power generation element 100. The anode of the power generation element 100 is electrically connected to the GND terminal (GND) of the electronic part 501. The cathode of the power generation element 100 is electrically connected to the Vcc terminal (Vcc) of the electronic part 501. The electronic apparatus 500 illustrated in Fig. 7B includes the power generation element 100 used as the main power source 502 and the electronic part 501 that can be driven using the power generation element 100. The power generation element 100 is an independent power source (such as an off-grid power source). In view of this, the electronic apparatus 500 can be, for example, a stand-alone type. Moreover, the power generation element 100 is an energy harvesting type. For the electronic apparatus 500 illustrated in Fig. 7B, a battery does not need to be replaced.

As illustrated in Fig. 7C, the electronic part 501 may include the power generation element 100. The anode of the power generation element 100 is electrically connected to, for example, a GND wiring of a circuit board (not illustrated). The cathode of the power generation element 100 is electrically connected to, for example, a Vcc wiring of the circuit board (not illustrated). In this case, the power generation element 100 can be used as, for example, the auxiliary power source 503 of the electronic part 501.

As illustrated in Fig. 7D, when the electronic part 501 includes the power generation element 100, the power generation element 100 can be used as, for example, the main power source 502 of the electronic part 501.

As illustrated in each of Fig. 7E to Fig. 7H, the electronic apparatus 500 may include the power generation device 200. The power generation device 200 includes the power generation element 100 as a source of electric energy.

In the embodiment illustrated in Fig. 7D, the electronic part 501 includes the power generation element 100 used as the main power source 502. Similarly, in the embodiment illustrated in Fig. 7H, the electronic part 501 includes the power generation device 200 used as a main power source. In these embodiments, the electronic part 501 has an independent power source. In view of this, the electronic part 501 can be, for example, a stand-alone type. The stand-alone electronic part 501 can be effectively used for, for example, an electronic apparatus that includes a plurality of electronic parts and in which at least one electronic part is apart from other electronic parts. An example of such an electronic apparatus 500 is a sensor. The sensor includes a sensor terminal (slave) and a controller (master) apart from the sensor terminal. Each of the sensor terminal and the controller is the electronic part 501. As long as the sensor terminal includes the power generation element 100 or the power generation device 200, it becomes a stand-alone sensor terminal, and wired electric power supply is not necessary. Since the power generation element 100 or the power generation device 200 is an energy harvesting type, replacement of a battery is also not necessary. The sensor terminal can also be regarded as one of the electronic apparatus 500. The sensor terminal regarded as the electronic apparatus 500 further includes, for example, an IoT wireless tag or the like, in addition to the sensor terminal of the sensor.

A common point in the respective embodiments illustrated in Fig. 7A to Fig. 7H is that the electronic apparatus 500 includes the power generation element 100 that converts thermal energy into electric energy and the electronic part 501 that can be driven using the power generation element 100 as the power source.

The electronic apparatus 500 may be an autonomous type that includes an independent power source. Examples of the autonomous electronic apparatus can include, for example, a robot and the like. Furthermore, the electronic part 501 that includes the power generation element 100 or the power generation device 200 may be an autonomous type that includes an independent power source. Examples of the autonomous electronic part can include, for example, a movable sensor terminal and the like.

### (Fifth Embodiment)

Next, the power generation element 100 and the power generation device 200 according to a fifth embodiment will be described. A difference between the above-described embodiments and the fifth embodiment is a point that one laminated body 61 is included. The descriptions of contents similar to those of the above-described embodiments will be omitted.

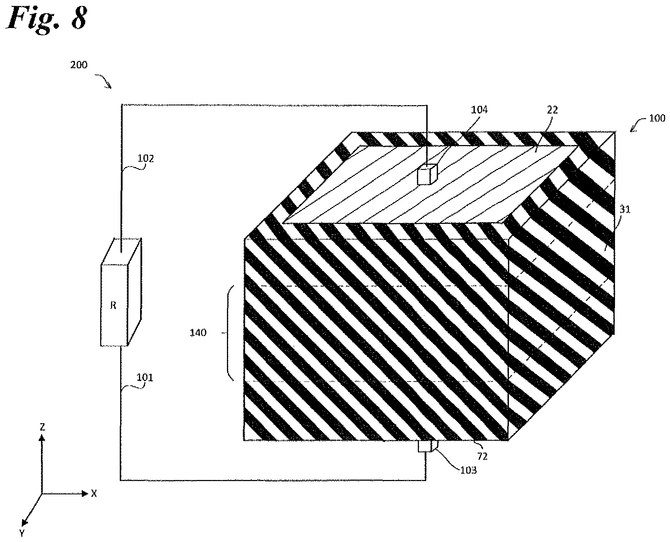

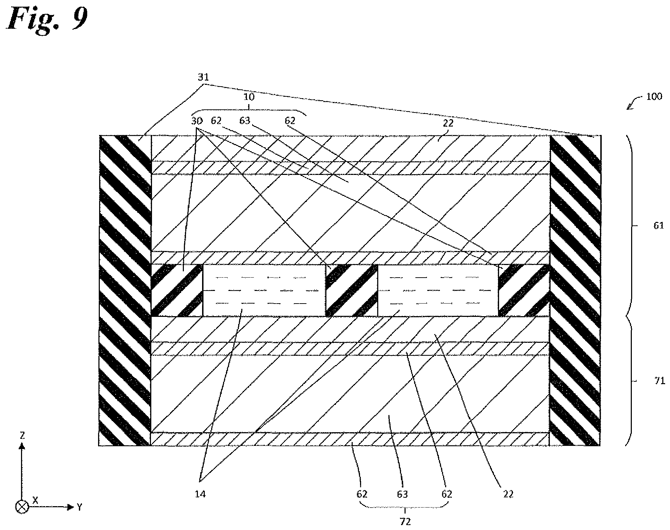

Fig. 8 is a schematic perspective view illustrating one example of the power generation element 100 and the power generation device 200 according to the fifth embodiment, and Fig. 9 is a schematic cross-sectional view illustrating one example of the power generation element 100 according to the fifth embodiment.

In the power generation element 100, as illustrated in Fig. 9, for example, the laminated body 61 is laminated on a connection layer 71. The laminated body 61 is in contact with the connection layer 71. The connection layer 71 includes a substrate 72 and the second electrode 22. The second electrode 22 is provided between the substrate 72 and the intermediate portions 14 and is in contact with, for example, the supporting portions 30. The substrate 72 has a conductive property and may include a configuration similar to that of the above-described substrate 11. The substrate 72 may have, for example, the degenerate portions 62 and the non-degenerate portion 63.

As illustrated in Fig. 8, for example, the second electrode 22 provided on an upper surface of the laminated body 61 is electrically connected to the second wiring 102 via a terminal 104. The substrate 72 provided on a lower surface of the connection layer 71 is electrically connected to the first wiring 101 via a terminal 103.

According to the embodiment, similarly to the above-described embodiments, the laminated body 61 includes the first electrode portion 10 that includes the substrate 11 having a conductive property, the second electrode 22, and the intermediate portions 14. The laminated body 61 is laminated on the connection layer 71. In view of this, a wiring is not necessary between the laminated body 61 and the connection layer 71, and an increase in resistance of the entire element can be suppressed. This allows improvement of an output voltage. Additionally, in association with the wiring becoming not necessary, structural simplification of the power generation element 100 can be ensured.

The connection layer 71 may be included in the power generation element 100 according to the above-described respective embodiments. The connection layer 71 may be laminated on at least any of an upper side and a lower side of the laminated body 61. Even in this case, the above-described effect can be obtained.

While the embodiments of the present invention have been described, these embodiments have been presented by way of example only, and are not intended to limit the scope of the invention. The novel embodiments described herein can be embodied in a variety of other configurations; furthermore, various omissions, substitutions and changes can be made without departing from the spirit of the invention. The accompanying claims and their equivalents cover such embodiments and modifications as would fall within the scope and spirit of the invention.

### DESCRIPTION OF REFERENCE SIGNS

- 1:: Laminated body
- 10:: First electrode portion
- 11:: Substrate
- 11a:: First main surface
- 11b:: Second main surface
- 12:: Oxidized film
- 13:: Resist
- 14:: Intermediate portion
- 140:: Gap portion
- 141:: Nanoparticles
- 142:: Solvent
- 21:: First electrode
- 22:: Second electrode
- 30:: Supporting portion
- 31:: First sealing portion
- 32:: Second sealing portion
- 51:: Laminated body
- 61:: Laminated body
- 62:: Degenerate portion
- 63:: Non-degenerate portion
- 71:: Connection layer
- 100:: Power generation element
- 101:: First wiring
- 102:: Second wiring
- 200:: Power generation device
- 500:: Electronic apparatus
- R:: Load
- S110:: Oxidized film formation step
- S120:: Resist formation step
- S130:: Etching step
- S140:: Resist removal step
- S150:: Electrode arrangement step
- S160:: Cutting step
- S170:: Lamination step
- S180:: Intermediate portion formation step
- Z:: First direction
- X:: Second direction
- Y:: Third direction

## Claims

1. A power generation element that converts thermal energy into electric energy, the power generation element comprising:
a plurality of laminated bodies that are laminated in a first direction, wherein
the plurality of laminated bodies include:
a first electrode portion that has a first main surface and a second main surface opposed to the first main surface in the first direction and includes a substrate having a conductive property;
a second electrode that is provided to be in contact with the first main surface and has a work function different from a work function of the substrate; and
an intermediate portion that is provided on the second main surface side and includes nanoparticles.

2. The power generation element according to claim 1, wherein
the substrate has a specific resistance value of 1×10⁻⁶Ω·cm or more and 1×10⁶Ω·cm or less.

3. The power generation element according to claim 1, wherein
the substrate has a specific resistance value smaller than a specific resistance value of the intermediate portion.

4. The power generation element according to claim 1, wherein
the first electrode portion includes a supporting portion that surrounds the intermediate portion and supports another of the laminated bodies, and
the substrate has a specific resistance value smaller than a specific resistance value of the supporting portion.

5. The power generation element according to claim 1, wherein
the first electrode portion includes a supporting portion that surrounds the intermediate portion and supports another of the laminated bodies, and
the intermediate portion has a specific resistance value smaller than a specific resistance value of the supporting portion.

6. The power generation element according to claim 1, wherein
the substrate has a thickness of 0.03 mm or more and 1.0 mm or less.

7. The power generation element according to claim 1, wherein
the substrate has a thickness of 1/10 or less of an outside dimension in a short side direction of the laminated bodies.

8. The power generation element according to claim 1, wherein
the first electrode portion is provided between the substrate and the intermediate portion and includes a first electrode that is in contact with the second main surface.

9. The power generation element according to claim 4, wherein
the supporting portion is an oxidized part of the substrate.

10. The power generation element according to claim 1, wherein
the substrate is a semiconductor and has a degenerate portion provided on at least any of the first main surface and the second main surface, and a non-degenerate portion.

11. A power generation element that converts thermal energy into electric energy, the power generation element comprising:
a laminated body that is laminated in a first direction; and
a connection layer, wherein
the laminated body includes:
a first electrode portion that has a first main surface and a second main surface opposed to the first main surface in the first direction and includes a substrate having a conductive property;
a second electrode that is provided to be in contact with the first main surface and has a work function different from a work function of the substrate; and
an intermediate portion that is provided on the second main surface side and includes nanoparticles, wherein
the connection layer includes the substrate.

12. A power generation device comprising the power generation element according to claim 1.

13. An electronic apparatus comprising the power generation element according to claim 1 and an electronic part configured to be driven by using the power generation element as a power source.

14. A manufacturing method for a power generation element that converts thermal energy into electric energy, the manufacturing method comprising:
a first electrode portion formation step of forming a first electrode portion that has a first main surface and a second main surface opposed to the first main surface in a first direction and includes a substrate having a conductive property;
a second electrode formation step of forming a second electrode having a work function different from a work function of the substrate so as to be in contact with the first main surface;
a lamination step of laminating the second electrode and the first electrode portion in this order two or more times; and
an intermediate portion formation step of forming an intermediate portion that includes nanoparticles between the second electrode and the second main surface.
